# FASCICULE DE BREVET EUROPEEN

(11) **EP 2 723 807 B1**
(45) Date de publication et mention de la délivrance du brevet: **01.06.2016**
(21) Numéro de dépôt: 12731593.5
(22) Date de dépôt: 21.06.2012
(51) Int. Cl.: C08K 3/22, C08K 5/524, C08K 5/526, C08L 77/06, G02B 1/04

(54) **COMPOSITION COMPRENANT UN POLYAMIDE SEMI-AROMATIQUE ET SES UTILISATIONS, NOTAMMENT POUR UN REFLECTEUR A DIODE ELECTROLUMINESCENTE**
ZUSAMMENSETZUNG MIT EINEM HALBAROMATISCHEN POLYAMID UND IHRE VERWENDUNG, INSBESONDERE FÜR SCHEINWERFER MIT EINER LEUCHTDIODE
COMPOSITION INCLUDING A SEMI-AROMATIC POLYAMIDE AND USES THEREOF, IN PARTICULAR FOR A REFLECTOR HAVING A LIGHT-EMITTING DIODE

(30) Priorité: 24.06.2011 FR 1155597
(43) Date de publication de la demande: 30.04.2014
(73) Titulaire: Arkema France, 92700 Colombes (FR)
(72) Inventeur: BRIFFAUD, Thierry, 27300 Caorches Saint Nicolas (FR); PINEAU Quentin, 27000 Evreux (FR); BLONDEL Philippe, 27300 Bernay (FR); MATSUNO Shinya, Shimogyo-ku Kyoto 600-8459 (JP)
(86) Numéro de dépôt international: PCT/FR2012/051418
(87) Numéro de publication internationale: WO 2012/175880

(56) Documents cités:
- WO-A1-2011/027562
- AU-B2- 751 426
- JP-A- 2006 257 314

## Description

### [Domaine de l'invention]

La présente invention a pour objet une composition comprenant un polyamide semi-aromatique ainsi que ses utilisations, notamment dans la fabrication de composants électroniques et, plus particulièrement, dans la fabrication de réflecteurs à diode électroluminescente (Light-Emitting Diode ou LED).

### [L'art antérieur et le problème technique]

Depuis quelques années déjà, la construction de certains types d'écrans d'équipements électroniques (télévisions, ordinateurs, téléphones, tablettes tactiles,...) recourt à l'intégration de diodes électroluminescentes (LED) comme sources d'illumination principale en raison de leur importante efficacité lumineuse.

Toutefois, pour que cette efficacité lumineuse s'inscrive dans la durée, il est nécessaire que les éléments réfléchissant la lumière générée par les LED ne s'altèrent pas, c'est-à-dire ne perdent pas leur couleur blanche, sous les températures élevées qui sont engendrées lors du processus de fabrication ou lors du fonctionnement de ces LED. De ce fait, il est nécessaire que ces éléments (réflecteurs) soient conçus dans des matériaux présentant une haute tenue en température.

Des matériaux présentant une telle tenue en température peuvent notamment être obtenus à partir de compositions comprenant au moins un polyamide semi-aromatique telles que décrites dans le document JP 2006-257314.

Plus particulièrement, la composition décrite dans le document JP 2006-257314 comprend, pour 100 parties en poids d'un polyamide semi-aromatique :
- de 5 à 100 parties en poids de dioxyde de titane TiO₂,
- de 20 à 100 parties en poids de renforts choisis parmi les charges sous forme de fibres et les charges sous forme d'aiguilles, et
- de 0,5 à 30 parties en poids d'hydroxyde de magnésium,
le polyamide semi-aromatique comprenant des unités d'acide dicarboxylique contenant de 50 à 100% en mol d'unités d'acide téréphtalique et des unités de diamine comprenant de 60 à 100% de 1,9-nonanediamine et/ou de 2-méthyl-1,8-octanediamine.

De telles compositions se révèlent satisfaisantes en termes de tenue thermique, signifiant que les propriétés du matériau obtenu à partir de celles-ci sont peu altérées sous l'effet de la température générée, soit lors de la fabrication des LED, soit par les LED en fonctionnement.

Toutefois, la Demanderesse a constaté que ces compositions ne répondaient pas de manière entièrement satisfaisante à un autre critère important, qui est la tenue à la lumière générée par les LED, afin d'optimiser encore l'efficacité lumineuse des écrans à LED en retardant la coloration, notamment le jaunissement, qui nuit à la réflectance du matériau obtenu à partir de ces compositions.

Il y a donc un besoin réel de trouver des compositions qui permettent d'obtenir un matériau pouvant constituer tout ou partie des réflecteurs des LED, ce matériau présentant simultanément une très bonne tenue thermique (tenue à la température, que celle-ci se produise lors du processus de fabrication des LED ou qu'elle soit générée par les LED en fonctionnement) et une très bonne tenue LED (tenue à la lumière générée par les LED).

### [Brève description de l'invention]

La Demanderesse a trouvé que ces tenue thermique et tenue LED sont conjointement atteintes avec un matériau obtenu à partir d'une composition comprenant, les pourcentages pondéraux étant donnés par rapport au poids total de la composition :
- de 30 à 97% en poids d'au moins un polyamide semi-aromatique comprenant :
   - de 55 à 100% en mol d'un motif répétitif (A) obtenu à partir de la polycondensation d'au moins une diamine aliphatique comprenant de 4 à 18 atomes de carbone et d'au moins un acide dicarboxylique aromatique dont l'acide téréphtalique, et
   - de 0 à 45% en mol d'un motif répétitif (B) obtenu à partir d'au moins un élément choisi parmi le groupe constitué par un lactame comprenant de 9 à 12 atomes de carbone, un acide aminocarboxylique non aromatique comprenant de 9 à 12 atomes de carbone et le produit de polycondensation d'au moins une diamine comprenant de 4 à 36 atomes de carbone et d'au moins un acide dicarboxylique non aromatique comprenant de 4 à 36 atomes de carbone,

- de 2 à 50% en poids de pigments blancs,
- de 0 à 50% en poids de renforts, et
- de 0,1 à 10% en poids d'au moins un hydroxyde métallique et/ou d'au moins un oxyde métallique, à l'exception d'un oxyde d'un métal de transition,
ladite composition comprenant en outre une phosphite organique, en une teneur pouvant aller jusqu'à 3% en poids.

La présente invention a également pour objet l'utilisation de la composition selon l'invention pour l'obtention d'un matériau destiné à constituer tout ou partie de réflecteurs à LED.

La présente invention a enfin pour objet un réflecteur à diode électroluminescente (LED) constitué en tout ou partie par un matériau obtenu à partir d'une composition selon l'invention.

### [Description détaillée de l'invention]

D'autres caractéristiques, aspects, objets et avantages de la présente invention apparaîtront encore plus clairement à la lecture de la description qui suit.

La nomenclature utilisée pour définir les polyamides est décrite dans la norme ISO 1874-1:1992 *"Plastiques - Matériaux polyamides (PA) pour moulage et extrusion - Partie 1 : Désignation",* notamment en page 3 (tableaux 1 et 2) et est bien connue de l'homme du métier.

Par ailleurs, il est précisé que les expressions "... de... à..." et "... entre... et..." utilisées dans cette description doivent s'entendre comme incluant les bornes citées.

L'invention se rapporte à une composition comprenant de 30 à 97% en poids d'au moins un polyamide semi-aromatique particulier qui sera détaillé ci-après, de 2 à 50% en poids de pigments blancs, de 0 à 50% en poids de renforts et de 0,1 à 10% en poids d'au moins un hydroxyde métallique et/ou d'au moins un oxyde métallique (à l'exception d'un oxyde d'un métal de transition), ladite composition comprenant en outre une phosphite organique, en une teneur pouvant aller jusqu'à 3% en poids.

Il est précisé que les pourcentages pondéraux qui viennent d'être cités sont donnés par rapport au poids total de la composition selon l'invention.

La Demanderesse a pu constater de manière inattendue et surprenante que la composition selon l'invention permettait de maintenir les propriétés de tenue thermique des réflecteurs au niveau de celles des réflecteurs obtenus à partir des compositions connues, notamment de JP 2006-257314 mais, par contre, permettait d'en améliorer les propriétés de tenue LED et ce, de manière significative.

La composition selon l'invention comprend de 30 à 97% en poids, par rapport au poids total de la composition, d'au moins un polyamide semi-aromatique.

De manière avantageuse, la proportion pondérale du ou des polyamides semi-aromatiques dans la composition est comprise entre 35 et 84% en poids et, avantageusement, entre 40 et 68% en poids, par rapport au poids total de la composition.

Selon un premier mode de réalisation de l'invention, le polyamide semi-aromatique de la composition est constitué :
- de 55 à 100% en mol d'un motif répétitif (A) obtenu à partir de la polycondensation d'une diamine aliphatique comprenant de 4 à 18 atomes de carbone et de l'acide téréphtalique, et
- de 0 à 45% en mol d'un motif répétitif (B) obtenu à partir d'un lactame comprenant de 9 à 12 atomes de carbone, d'un acide aminocarboxylique comprenant de 9 à 12 atomes de carbone ou du produit de polycondensation d'une diamine comprenant de 4 à 36 atomes de carbone et d'un acide dicarboxylique non aromatique comprenant de 4 à 36 atomes de carbone.

Dans une variante particulière de l'invention, le polyamide semi-aromatique peut ne comprendre que des motifs répétitifs (A) et, par conséquent, être un homopolyamide.

Selon un second mode de réalisation de l'invention, le polyamide semi-aromatique de la composition comprend :
- de 55 à 100% en mol d'un motif répétitif (A) obtenu à partir de la polycondensation d'au moins une diamine aliphatique comprenant de 4 à 18 atomes de carbone et d'au moins un acide dicarboxylique aromatique dont l'acide téréphtalique, et
- de 0 à 45% en mol d'un motif répétitif (B) obtenu à partir d'au moins un élément choisi parmi le groupe constitué par un lactame comprenant de 9 à 12 atomes de carbone, un acide aminocarboxylique comprenant de 9 à 12 atomes de carbone et le produit de polycondensation d'au moins une diamine comprenant de 4 à 36 atomes de carbone et d'au moins un acide dicarboxylique non aromatique comprenant de 4 à 36 atomes de carbone.

Dans une autre variante particulière de l'invention, le polyamide semi-aromatique peut ne comprendre que des motifs répétitifs (A) et, par conséquent, correspondre à un copolyamide qui n'est formé que de motifs semi-aromatiques.

Dans une variante du premier ou second mode de réalisation de l'invention, le polyamide semi-aromatique de la composition selon l'invention peut comprendre de 60 à 90% en mol du motif répétitif (A) et de 10 à 40% en mol du motif répétitif (B).

Dans une autre variante, le polyamide semi-aromatique de la composition selon l'invention peut être constitué de 70 à 80% en mol du motif répétitif (A) et de 20 à 30% en moles du motif répétitif (B).

Avantageusement, le ou les polyamide(s) semi-aromatique(s) sont caractérisés par une température de fusion d'au moins 260°C, préférentiellement d'au moins 270°C et, encore plus préférentiellement, d'au moins 280°C, la température de fusion étant mesurée par DSC, selon la norme ISO 11357.

Sauf indication contraire, la description qui suit est valable pour le polyamide semi-aromatique, que ce dernier réponde au premier mode de réalisation ou au second mode de réalisation mentionné ci-dessus.

Le motif répétitif (A) du polyamide semi-aromatique de la composition selon l'invention est obtenu à partir de la polycondensation d'une ou d'au moins une diamine et d'un ou d'au moins un acide dicarboxylique aromatique, ledit au moins un acide dicarboxylique aromatique étant l'acide téréphtalique. En d'autres termes, si un seul acide dicarboxylique aromatique est mis en oeuvre lors de la polycondensation, il s'agit de l'acide téréphtalique. Dans le cas où plusieurs acides dicarboxyliques aromatiques sont mis en oeuvre lors de la polycondensation, l'acide téréphtalique est nécessairement présent parmi ces acides, de préférence dans une proportion molaire majoritaire par rapport à l'ensemble des autres acides dicarboxyliques aromatiques.

La diamine utilisée pour l'obtention de ce motif répétitif (A) est une diamine aliphatique qui présente une chaine principale linéaire comprenant au moins 3 atomes de carbone.

Cette chaine principale linéaire peut, le cas échéant, comporter un ou plusieurs substituants méthyle et/ou éthyle ; dans cette dernière configuration, on parle de "diamine aliphatique ramifiée". Dans le cas où la chaine principale ne comporte aucun substituant, la diamine aliphatique est dite "diamine aliphatique linéaire".

Qu'elle comporte ou non des substituants méthyle et/ou éthyle sur la chaine principale, la diamine aliphatique utilisée pour l'obtention de ce motif répétitif (A) comprend de 4 à 18 atomes de carbone, avantageusement de 6 à 14 atomes de carbone et, préférentiellement, 10 atomes de carbone.

Lorsque cette diamine est une diamine aliphatique linéaire, elle répond alors à la formule H₂N-(CH₂)ₓ-NH₂ et peut être choisie parmi la butanediamine, la pentanediamine, l'hexanediamine, l'heptanediamine, l'octanediamine, la nonanediamine, la décanediamine, l'undécanediamine, la dodécanediamine, la tridécanediamine, la tétradécanediamine, l'hexadécanediamine, l'octadécanediamine et l'octadécènediamine. Les diamines aliphatiques linéaires qui viennent d'être citées présentent toutes l'avantage d'être bioressourcées au sens de la norme ASTM D6866.

Lorsque cette diamine est une diamine aliphatique ramifiée, elle peut notamment être la méthyl-2 pentanediamine ou la 2-méthyl-1,8-octanediamine.

La diamine est avantageusement une diamine aliphatique linéaire au sens de l'invention. De manière préférée, cette diamine est la décanediamine.

Pour l'obtention de ce motif répétitif (A), on peut envisager d'utiliser une seule diamine aliphatique comprenant de 4 à 18, avantageusement de 6 à 14 et, préférentiellement, 10 atomes de carbone.

On peut également envisager le mélange de deux, ou plus, diamines aliphatiques, toutes ces diamines aliphatiques comprenant nécessairement de 4 à 18, avantageusement de 6 à 14 et, préférentiellement, 10 atomes de carbone et étant bien entendu distinctes deux à deux. On est alors dans le second mode de réalisation de l'invention.

Le ou les acides dicarboxyliques utilisés pour l'obtention de ce motif répétitif (A) sont des acides dicarboxyliques aromatiques, parmi lesquels il y a nécessairement l'acide téréphtalique (noté T).

Ainsi, pour l'obtention de ce motif répétitif (A), on peut envisager de n'utiliser que l'acide téréphtalique.

On peut également envisager un mélange de deux, ou plus, acides dicarboxyliques aromatiques dont au moins l'acide téréphtalique, ces autres acides étant bien entendu distincts deux à deux. On est alors dans le second mode de réalisation de l'invention.

Ce ou ces autres acides dicarboxyliques aromatiques peuvent être choisis parmi l'acide isophtalique (noté I) et les diacides naphtaléniques. Parmi les acides naphtaléniques, on peut notamment citer l'acide naphtalène-2,6-dicarboxylique.

Plus préférentiellement, le motif répétitif (A) désigne les motifs suivants : 6.T, 8.T, 9.T, 10.T, 11.T, 12.T, 10.T/6.T, 10.T/12.T, 6.T/6.I et 10.T/10.I.

Le motif répétitif (B) du polyamide semi-aromatique de la composition selon l'invention est obtenu à partir d'au moins un des composés suivants :
- d'un lactame,
- d'acide aminocarboxylique, et/ou
- du produit de polycondensation d'une diamine et d'un acide dicarboxylique non aromatique.

Pour l'obtention de ce motif répétitif (B), on peut envisager la mise en oeuvre d'un seul des composés qui viennent d'être cités.

Pour l'obtention de ce motif répétitif (B), on peut également envisager le mélange de deux ou plus, des composés qui viennent d'être cités. On est alors dans le second mode de réalisation de l'invention.

Le lactame utilisé pour l'obtention de ce motif répétitif (B) est un lactame qui comprend de 9 à 12 atomes de carbone et, avantageusement, de 10 à 12 atomes de carbone. Il peut ainsi être choisi parmi le décanolactame, l'undécanolactame et le lauryllactame et est, préférentiellement, le lauryllactame.

Pour l'obtention de ce motif répétitif (B), on peut envisager d'utiliser un seul lactame comprenant de 9 à 12 atomes de carbone.

On peut également envisager le mélange de deux, ou plus, lactames, tous ces lactames comprenant nécessairement de 9 à 12 atomes de carbone et étant bien entendu distincts deux à deux. On est alors dans le second mode de réalisation de l'invention.

L'acide aminocarboxylique utilisé pour l'obtention de ce motif répétitif (B) est un acide aminocarboxylique qui comprend de 9 à 12 atomes de carbone et, avantageusement, de 10 à 12 atomes de carbone.

Dans une variante avantageuse de l'invention, cet acide aminocarboxylique est linéaire et non ramifié. Il peut ainsi être choisi parmi l'acide 9-aminononanoïque, l'acide 10-aminodécanoïque, l'acide 10-aminoundécanoïque, l'acide 11-aminoundécanoïque et l'acide 12-aminododécanoïque.

Préférentiellement, l'acide aminocarboxylique est l'acide 11-aminoundécanoïque qui présente en outre l'avantage d'être bioressourcé au sens de la norme ASTM D6866.

Pour l'obtention de ce motif répétitif (B), on peut envisager d'utiliser un seul acide aminocarboxylique comprenant de 9 à 12 atomes de carbone.

On peut également envisager le mélange de deux, ou plus, acides aminocarboxyliques, tous ces acides aminocarboxyliques comprenant nécessairement de 9 à 12 atomes de carbone et étant bien entendu distincts deux à deux. On est alors dans le second mode de réalisation de l'invention

Le motif répétitif (B) peut également être obtenu à partir de la polycondensation d'une ou d'au moins une diamine et d'un ou d'au moins un acide dicarboxylique non aromatique, ces diamine et acide dicarboxylique non aromatique comprenant chacun de 4 à 36, avantageusement de 6 à 18 et, préférentiellement de 10 à 14 atomes de carbone.

La diamine utilisée pour l'obtention de ce motif répétitif (B) peut être choisie parmi les diamines aliphatiques, linéaires ou ramifiées, les diamines cycloaliphatiques et les diamines alkylaromatiques.

Lorsque cette diamine est aliphatique et linéaire, elle répond à la formule H₂N-(CH₂)ₓ-NH₂ et peut être choisie parmi la butanediamine, la pentanediamine, l'hexanediamine, l'heptanediamine, l'octanediamine, la nonanediamine, la décanediamine, l'undécanediamine, la dodécanediamine, la tridécanediamine, la tetradécanediamine, l'hexadécanediamine, l'octadécanediamine, l'octadécènediamine, l'eicosanediamine, la docosanediamine et les diamines obtenues à partir d'acides gras.

Lorsque cette diamine est aliphatique et ramifiée, elle peut notamment être la méthyl-2 pentanediamine ou la 2-méthyl-1,8-octanediamine.

Lorsque cette diamine est cycloaliphatique, elle peut être choisie parmi la bis(3,5-dialkyl-4-aminocyclohexyl)méthane, la bis(3,5-dialkyl-4-aminocyclohexyl)éthane, la bis(3,5-dialkyl-4-aminocyclo-hexyl)propane, la bis(3,5-dialkyl-4-aminocyclo-hexyl)butane, la bis-(3-méthyl-4-aminocyclohexyl)-méthane (BMACM ou MACM), la p-bis(aminocyclohexyl)-méthane (PACM) et l'isopropylidènedi(cyclohexylamine) (PACP). Elle peut également comporter les squelettes carbonés suivants : norbornyl méthane, cyclohexylméthane, dicyclohexylpropane, di(méthylcyclohexyl), di(méthylcyclohexyl) propane. Une liste non-exhaustive de ces diamines cycloaliphatiques est donnée dans la publication "Cycloaliphatic Amines" (Encyclopaedia of Chemical Technology, Kirk-Othmer, 4th Edition (1992), pp. 386-405).

Lorsque cette diamine est alkylaromatique, elle peut être choisie parmi la 1,3-xylylène diamine et la 1,4-xylylène diamine.

L'acide dicarboxylique utilisé pour l'obtention de ce motif répétitif (B) est, quant-à-lui, non aromatique et peut être choisi parmi les acides dicarboxyliques aliphatiques, linéaires ou ramifiés, et les acides dicarboxyliques cycloaliphatiques.

Lorsque cet acide dicarboxylique est aliphatique et linéaire, il peut être choisi parmi l'acide succinique, l'acide pentanedioïque, l'acide adipique, l'acide heptanedioïque, l'acide octanedioïque, l'acide azélaïque, l'acide sébacique, l'acide undécanedioïque, l'acide dodécanedioïque, l'acide brassylique, l'acide tetradécanedioïque, l'acide hexadécanedioïque, l'acide octadécanedioïque, l'acide octadécènedioïque, l'acide eicosanedioïque, l'acide docosanedioïque et les dimères d'acides gras contenant 36 carbones.

Les dimères d'acides gras mentionnés ci-dessus sont des acides gras dimérisés obtenus par oligomérisation ou polymérisation d'acides gras monobasiques insaturés à longue chaîne hydrocarbonée (tels que l'acide linoléïque et l'acide oléïque), comme décrit notamment dans le document EP 0 471 566.

Lorsque cet acide dicarboxylique est cycloaliphatique, il peut comporter les squelettes carbonés suivants : norbornylméthane, cyclohexane, cyclohexylméthane, dicyclohexylméthane, dicyclohexylpropane, di(méthylcyclohexyl), di(méthylcyclohexyl)propane.

Pour l'obtention de ce motif répétitif (B), on peut envisager d'utiliser une seule diamine et un seul acide dicarboxylique non aromatique.

Pour l'obtention de ce motif répétitif (B), on peut également envisager le mélange de deux, ou plusieurs, diamines avec un, deux ou plusieurs acides dicarboxyliques non aromatiques, mais également le mélange de deux, ou plusieurs, acides dicarboxyliques non aromatiques avec une, deux ou plusieurs diamines. Dans tous les cas, tous ces diamines et acides dicarboxyliques non aromatiques comprennent chacun de 4 à 36 atomes de carbone et sont bien entendu distincts deux à deux. On est alors dans le second mode de réalisation de l'invention.

De préférence, le motif répétitif (B) désigne des motifs aliphatiques linéaires non ramifiés, que ces motifs proviennent d'un lactame, d'un acide aminocarboxylique ou du produit de réaction d'une diamine et d'un acide dicarboxylique non aromatique.

Plus préférentiellement, le motif répétitif (B) désigne les motifs suivants : 6, 11, 12, 6.10, 6.12, 6.14, 6.18, 10.10, 10.12, 10.14, 10.18, 12.10, 12.12, 12.14 et 12.18.

Parmi les combinaisons envisageables pour le premier mode de réalisation de l'invention, les polyamides semi-aromatiques suivants présentent un intérêt particulièrement marqué : il s'agit des copolyamides répondant à l'une des formules choisies parmi 10/6.T, 11/6.T, 12/6.T, 10/9.T, 10/10.T, 10/11.T, 10/12.T, 11/9.T, 11/10.T, 11/11.T, 11/12.T, 12/9.T, 12/10.T, 12/11.T, 12/12.T, 6.10/6.T, 6.12/6.T, 10.10/6.T, 10.12/6.T, 6.10/10.T, 6.12/10.T, 10.10/10.T, 10.12/10.T, 6.10/12.T, 6.12/12.T, 10.10/12.T et 10.12/12.T.

Parmi les combinaisons envisageables pour le second mode de réalisation de l'invention, les polyamides semi-aromatiques suivants présentent un intérêt particulièrement marqué : il s'agit des copolyamides répondant à l'une des formules choisies parmi 11/12/6.T, 11/12/10.T, 11/12/11.T, 11/12/12.T, 10/6.T/10.T, 10/6.T/11.T, 10/6.T/12.T, 10/10.T/11.T, 10/10.T/12.T, 10/11.T/12.T, 11/6.T/10.T, 11/6.T/11.T, 11/6.T/12.T, 11/10.T/11.T, 11/10.T/12.T, 11/11.T/12.T, 12/6.T/10.T, 12/6.T/11.T, 12/6.T/12.T, 12/10.T/11.T, 12/10.T/12.T, 12/11.T/12.T, 10/6.T/6.I, 10/10.T/10.I, 11/6.T/6.I, 11/9.T/9.I, 11/10.T/10.I, 11/11.T/11.I, 11/12.T/12.I, 12/6.T/6.I, 12/9.T/9.I, 12/10.T/10.I, 12/11.T/11.I et 12/12.T/12.I.

La composition selon l'invention peut comprendre un seul polyamide semi-aromatique ou un mélange de deux ou plusieurs polyamides semi-aromatiques tels que décrits ci-dessus, ce ou ces polyamides semi-aromatiques étant conformes au premier et/ou au second mode de réalisation.

En plus du ou des polyamide(s) semi-aromatique(s), la composition selon l'invention comprend de 2 à 50% en poids, par rapport au poids total de la composition, de pigments blancs.

En effet, les pigments blancs permettent d'améliorer la réflectance des matériaux obtenus à partir des compositions selon l'invention, ce qui présente un intérêt majeur pour une utilisation dans la fabrication de réflecteurs à LED.

De manière avantageuse, la proportion pondérale des pigments blancs dans la composition est comprise entre 10 et 40% en poids et, avantageusement, entre 20 et 35% en poids, par rapport au poids total de la composition.

Les pigments blancs couramment utilisés sont l'oxyde de zinc ZnO et le dioxyde de titane TiO₂. Avantageusement, on utilise le dioxyde de titane TiO₂.

La composition selon l'invention peut en outre comprendre des renforts, en une teneur pouvant aller jusqu'à 50% en poids, par rapport au poids total de la composition.

De manière avantageuse, la proportion pondérale en renforts est comprise entre 5 et 30% en poids et, avantageusement, entre 10 et 15% en poids, par rapport au poids total de la composition.

Selon une variante avantageuse, les renforts se présentent sous la forme de fibres, blanches ou transparentes. Ces fibres peuvent notamment être choisies parmi les fibres de verre, les fibres de mica, les fibres d'aramide (polyamides entièrement aromatiques). Avantageusement, les fibres sont des fibres de verre.

Les fibres de verre couramment utilisées ont une dimension avantageusement comprise entre 0,20 et 25 mm.

Pour améliorer l'adhésion des fibres au(x) polyamide(s) semi-aromatique(s), on peut ajouter à la composition un agent de couplage tel que les silanes ou les titanates, qui sont connus de l'homme de l'art.

La composition selon l'invention comprend en outre de 0,1 à 10% en poids, par rapport au poids total de la composition, d'au moins un hydroxyde métallique et/ou d'au moins un oxyde métallique, à l'exception d'un oxyde d'un métal de transition.

De manière avantageuse, la proportion pondérale en hydroxyde et/ou en oxyde métallique mentionné(s) ci-dessus est comprise entre 0,5 et 5% en poids et, avantageusement, entre 1 et 3,5% en poids, par rapport au poids total de la composition.

Cet hydroxyde métallique peut se présenter sous une forme d'oxyde-hydroxyde d'un seul ou de plusieurs métaux.

Selon une version avantageuse, l'hydroxyde métallique est choisi parmi l'hydroxyde de magnésium Mg(OH)₂, l'hydroxyde de calcium Ca(OH)₂ et l'hydroxyde d'aluminium Al(OH)₃ et est, avantageusement, l'hydroxyde de magnésium Mg(OH)₂.

L'oxyde métallique qui est utilisé peut être un oxyde d'un seul ou de plusieurs métaux, le ou les métaux n'étant pas un(des) métal(aux) de transition. Il peut notamment s'agir d'un oxyde d'un métal alcalin et/ou d'un métal alcalino-terreux. De manière préférée, on utilise un oxyde d'un métal alcalino-terreux.

Selon une version avantageuse, l'oxyde métallique est choisi parmi l'oxyde de magnésium MgO et l'oxyde de calcium CaO.

On peut bien entendu utiliser des mélanges d'un seul ou de plusieurs hydroxydes métalliques avec un seul ou plusieurs oxydes métalliques tels que ceux mentionnés ci-dessus.

La composition selon l'invention comprend en outre une phosphite organique, en une teneur pouvant aller jusqu'à 3% en poids, par rapport au poids total de la composition.

De manière avantageuse, la proportion pondérale en phosphite organique est comprise entre 0,1 et 2% en poids et, avantageusement, entre 0,5 et 1% en poids, par rapport au poids total de la composition.

Les inventeurs ont observé que l'addition, dans des quantités relativement faibles, de cette phosphite organique dans la composition de l'invention permet d'améliorer l'efficacité lumineuse par l'amélioration la tenue LED conjuguée au maintien de la tenue thermique du matériau obtenu à partir de ladite composition.

Une composition conforme à l'invention peut comprendre en outre au moins un additif habituel des polyamides.

Parmi ces additifs, on peut notamment citer les charges, les agents ignifugeants additionnés ou non d'activateurs d'ignifugation, les stabilisants (tels que stabilisants UV), les plastifiants, les agents tensioactifs, les azurants optiques, les anti-oxydants, les agents démoulants et leurs mélanges.

En fonction de leur nature, les additifs peuvent représenter jusqu'à 90% en poids, avantageusement de 1 à 60% en poids, de préférence de 20 à 50% en poids et, plus préférentiellement, de l'ordre de 40% en poids, par rapport au poids total de la composition.

Parmi les charges susceptibles d'être introduites dans la composition de l'invention, on peut citer les charges minérales telles que le kaolin, la wollastonite, le talc, la silice, les zéolithes, étant précisé que le talc et la silice sont également connus comme agents nucléants.

Parmi les agents d'ignifugation connus, on peut également citer le cyanurate de mélamine ainsi que le phosphore, ses dérivés tels que le phosphore rouge (US 3 778 407), les phosphates et les phosphinates. On peut également citer les agents d'ignifugation et les activateurs d'ignifugation décrits dans le document FR 2 900 409 qui sont particulièrement adaptés aux compositions à base de polyamides semi-aromatiques.

Il est précisé qu'en ajoutant des additifs phosphorés, dont certains peuvent être de surcroît des agents ignifugeants, on améliore encore la réflectance des matériaux obtenus à partir de la composition selon l'invention.

Parmi les stabilisants UV généralement utilisés dans les compositions pour matériaux destinés aux réflecteurs à LED, on peut citer les stabilisants à la lumière à amine bloqué dits stabilisants HALS (Hindered Amine Light Stabiliser).

Les stabilisants, et notamment les stabilisants UV, peuvent représenter jusqu'à 6% en poids, avantageusement de 0,05 à 3% en poids, de préférence de 0,1 à 1% en poids, par rapport au poids total de la composition.

Parmi les anti-oxydants, on peut citer les anti-oxydants phénoliques.

Parmi les agents démoulants, on peut citer les cires naturelles, le stéarate de calcium et le montanate de calcium.

Une composition conforme à l'invention peut également comprendre en outre au moins un deuxième polymère.

Avantageusement, ce deuxième polymère peut être choisi parmi un polyamide semi-cristallin, un polyamide amorphe, un copolyamide semi-cristallin, un copolyamide amorphe, un polyétheramide, un polyesteramide, le polysulfure de phénylène (PPS), un polyester aromatique, un arylamide et leurs mélanges.

En particulier, ce deuxième polymère peut être une ou plusieurs polyoléfines fonctionnelles (telles qu'un modifiant-choc) ou non fonctionnelles, réticulées ou non.

Les compositions selon l'invention peuvent être préparées par toute méthode qui rend possible l'obtention d'un mélange homogène, telle que l'extrusion à l'état fondu, le compactage ou encore le malaxeur à rouleau.

Plus particulièrement, la composition selon l'invention est préparée par mélange à l'état fondu de tous les produits, par exemple dans un procédé dit "en direct".

Avantageusement, la composition peut être obtenue sous forme de granulés par compoundage sur un outil connu de l'homme de l'art tel qu'une extrudeuse bivis, un comalaxeur ou un mélangeur interne.

La composition selon l'invention obtenue par le procédé de préparation décrit ci-dessus peut être ensuite transformée pour une utilisation ou une transformation ultérieure connue par l'homme de l'art à l'aide d'outils tels qu'une presse à injecter ou encore une extrudeuse.

L'invention porte ainsi aussi sur un article obtenu par injection, extrusion, extrusion-soufflage, coextrusion, multi-injection à partir d'au moins une composition telle que définie ci-dessus.

Le procédé de préparation de la composition selon l'invention peut aussi utiliser une extrudeuse bi-vis alimentant, sans granulation intermédiaire, une presse à injecter ou une extrudeuse selon un dispositif de mise en oeuvre connu par l'homme de l'art.

La présente invention concerne également l'utilisation d'une composition telle que décrite ci-dessus pour constituer une poudre, des granulés, une structure monocouche ou au moins une couche d'une structure multicouche.

La composition telle que décrite ci-dessus peut être utilisée pour l'obtention de pièces, en particulier de pièces injectées.

Parmi ces pièces, on citera tout particulièrement les réflecteurs à diode électroluminescente (LED).

De telles pièces pouvant être destinées au domaine industriel en général, et à l'industrie électrique et électronique en particulier.

De telles pièces peuvent tout particulièrement être traitées par la technologie dite des éléments installés en surface ou SMT (surface-mount technology) à partir de la composition selon l'invention. Cette composition peut en particulier être utilisée comme composition de brasage.

La présente invention concerne enfin un réflecteur à diode électroluminescente (LED) qui peut être constitué en tout ou partie par un matériau obtenu à partir d'une composition telle que décrite ci-dessus.

### [Exemples]

### Produits

Les compositions qui ont été testés ont été préparées à partir des produits suivants :
Polyamide 11/6.T : ce copolyamide, qui comprend 33% en mol de motif répétitif (B) issu de l'acide 11-aminocarboxylique et 67% en mol de motif répétitif (A) issu de la polycondensation de l'hexanediamine et de l'acide téréphtalique, a une température de transition vitreuse Tg de 95°C, une température de fusion Tm de 315°C, une viscosité inhérente de 0,9 et une enthalpie de fusion de 50 J/g.
Polyamide 11/10.T : ce copolyamide, qui comprend 10% en mol de motif répétitif (B) issu de l'acide 11-aminocarboxylique et 90% en mol de motif répétitif (A) issu de la polycondensation de la décanediamine et de l'acide téréphtalique, a une température de transition vitreuse Tg de 95°C, une température de fusion Tm de 305°C, une viscosité inhérente de 0,9 et une enthalpie de fusion de 60 J/g.
TiO₂ : cet oxyde de titane correspond au grade Kronos 2222 commercialisé par la société Kronos.
Fibres de verre (FV) : ces fibres de verre correspondent au grade CS 03 JA FT 692 commercialisé par la société Asahi.
Mg(OH)₂: cet hydroxyde de magnésium correspond au grade Magnifin H10 commercialisé par la société Albemarle.
Phosphite : cette phosphite organique correspond au grade Irgafos PEP-Q commercialisé par la société Ciba.
Talc : cet agent nucléant correspond au grade Steamic 00S D G commercialisé par la société Luzenac NV.
Anti-oxydant : il s'agit du grade ADK STAB AO80 qui est un anti-oxydant phénolique commercialisé par la société Adeka Palmarole.
Agent démoulant : cet agent est du stéarate de calcium.
HALS : ce stabilisant UV correspond au grade Chimasorb 944 commercialisé par la société Ciba.

### Compositions 1 à 6 / Eprouvettes A à F

Les compositions ont été préparées par compoundage (mélange) à l'état fondu sur une extrudeuse bi-vis Werner-Pfleiderer ZSK40, avec une vitesse de vis de 250 tours/minute, un débit de 60 kg/h et une température de 320°C.

La formulation de chacune des six compositions 1 à 6 réalisées est donnée dans le Tableau 1 ci-dessous.

**Tableau 1**

| **Composition** | **1** | **2** | **3** | **4** | **5** | **6** |
|---|---|---|---|---|---|---|
| 11/6.T | 51,6 | 49,2 | 48,7 | 0 | 0 | 0 |
| 11/10.T | 0 | 0 | 0 | 51,6 | 49,2 | 48,7 |
| TiO₂ | 35 | 35 | 35 | 35 | 35 | 35 |
| FV | 10 | 10 | 10 | 10 | 10 | 10 |
| Mg(OH)₂ | 0,6 | 3 | 3 | 0,6 | 3 | 3 |
| Phosphite | 0 | 0 | 0,5 | 0 | 0 | 0,5 |
| Talc | 2 | 2 | 2 | 2 | 2 | 2 |
| Anti-oxydant | 0,4 | 0,4 | 0,4 | 0,4 | 0,4 | 0,4 |
| Agent démoulant | 0.2 | 0.2 | 0.2 | 0.2 | 0.2 | 0.2 |
| HALS | 0,2 | 0,2 | 0,2 | 0,2 | 0,2 | 0,2 |

Les compositions 3 et 6 sont deux compositions conformes à l'invention tandis que les compositions 1, 2, 4 et 5 sont des compositions comparatives.

Des éprouvettes A à F ont été respectivement réalisées à partir de chacune des compositions 1 à 6 conformément à la norme ISO R527.

### Résultats des tests

Pour évaluer la tenue aux hautes températures (notée "tenue thermique" dans le Tableau 2 ci-après) des matériaux obtenus à partir des six compositions A à F, des tests de vieillissement, dans l'air chaud à 170 °C et pendant 168 heures, ont été conduits sur les éprouvettes mentionnées ci-avant.

Pour évaluer la tenue à la lumière générée par les LED (ci-après "tenue LED" dans le Tableau 2 ci-après) de ces mêmes matériaux, les éprouvettes mentionnées ci-avant ont été soumises à une lumière bleue LED (longueur d'onde de 440 nm), dans un environnement à 80°C et pendant 400 heures.

La tenue thermique ainsi que la tenue LED des éprouvettes ont été respectivement évaluées. Les valeurs obtenues sont reportées dans le Tableau 2 ci-dessous, étant précisé que chacune des abréviations suivantes :
- "-" signifie "mauvais"
- "+-" signifie "moyen"
- "+" signifie "bon"
- "++" signifie "très bon"
- "+++" signifie "excellent"

**Tableau 2**

| **Composition** | **1** | **2** | **3** | **4** | **5** | **6** |
|---|---|---|---|---|---|---|
| **Eprouvette** | A | B | C | D | E | F |
| Tenue thermique | + | + | + | ++ | ++ | ++ |
| Tenue LED | - | + | ++ | +- | ++ | +++ |

On peut observer que, si la tenue thermique n'est pas modifiée par l'ajout de 0,5% en poids de phosphite dans les compositions selon l'invention (mêmes valeurs de tenue thermique entre les éprouvettes C selon l'invention et les éprouvettes comparatives B, d'une part, et les éprouvettes F selon l'invention et les éprouvettes comparatives E, d'autre part), la tenue LED est améliorée de façon significative :
- en passant de "bon" pour les éprouvettes comparatives B à "très bon" dans le cas des éprouvettes C,
- en passant de "très bon" pour les éprouvettes comparatives E à "excellent" dans le cas des éprouvettes F.

En comparant entre elles les éprouvettes comparatives A et B, d'une part, ainsi que les éprouvettes D et E, d'autre part, il ressort également de ce

Tableau 2 que la tenue LED peut déjà être améliorée, en l'absence de phosphite organique, en faisant varier la proportion pondérale d'hydroxyde de magnésium.

Toutefois, la combinaison de l'hydroxyde de magnésium avec la phosphite organique dans les compositions selon l'invention permet d'atteindre les valeurs de tenue LED les plus performantes, les autres composés et leur proportion pondérale respective étant comparables.

## Revendications

1. Composition comprenant, les pourcentages pondéraux étant donnés par rapport au poids total de la composition :
- de 30 à 97% en poids d'au moins un polyamide semi-aromatique comprenant :
. de 55 à 100% en mol d'un motif répétitif (A) obtenu à partir de la polycondensation d'au moins une diamine aliphatique comprenant de 4 à 18 atomes de carbone et d'au moins un acide dicarboxylique aromatique dont l'acide téréphtalique, et
. de 0 à 45% en mol d'un motif répétitif (B) obtenu à partir d'au moins un élément choisi parmi le groupe constitué par un lactame comprenant de 9 à 12 atomes de carbone, un acide aminocarboxylique non aromatique comprenant de 9 à 12 atomes de carbone et le produit de polycondensation d'au moins une diamine comprenant de 4 à 36 atomes de carbone et d'au moins un acide dicarboxylique non aromatique comprenant de 4 à 36 atomes de carbone,
- de 2 à 50% en poids de pigments blancs,
- de 0 à 50% en poids de renforts, et
- de 0,1 à 10% en poids d'au moins un hydroxyde métallique et/ou d'au moins un oxyde métallique, à l'exception d'un oxyde d'un métal de transition,
ladite composition comprenant en outre une phosphite organique, en une teneur pouvant aller jusqu'à 3% en poids.

2. Composition selon la revendication 1, **caractérisée en ce que** le ou les polyamide(s) semi-aromatique(s) ont une température de fusion d'au moins 260°C, la température de fusion étant mesurée par DSC, selon la norme ISO 11357.

3. Composition selon la revendication 1, **caractérisée en ce que** le ou les polyamide(s) semi-aromatique(s) ont une température de fusion d'au moins 270°C, la température de fusion étant mesurée par DSC, selon la norme ISO 11357.

4. Composition selon la revendication 1, **caractérisée en ce que** le ou les polyamide(s) semi-aromatique(s) ont une température de fusion d'au moins 280°C, la température de fusion étant mesurée par DSC, selon la norme ISO 11357.

5. Composition selon l'une quelconque des revendications 1 à 4, **caractérisée en ce que** la diamine aliphatique du motif répétitif (A) est linéaire et comprend de 6 à 14 atomes de carbone.

6. Composition selon l'une quelconque des revendications 1 à 4, **caractérisée en ce que** la diamine aliphatique du motif répétitif (A) est linéaire et comprend 10 atomes de carbone.

7. Composition selon l'une quelconque des revendications 1 à 6, **caractérisée en ce que** le lactame comprend de 10 à 12 atomes de carbone.

8. Composition selon l'une quelconque des revendications 1 à 7, **caractérisée en ce que** l'acide aminocarboxylique comprend de 10 à 12 atomes de carbones.

9. Composition selon l'une quelconque des revendications 1 à 7, **caractérisée en ce que** l'acide aminocarboxylique comprend 11 atomes de carbone.

10. Composition selon l'une quelconque des revendications 1 à 9, **caractérisée en ce que** la teneur en pigments blancs est comprise entre 10 et 40% en poids par rapport au poids total de la composition.

11. Composition selon l'une quelconque des revendications 1 à 9, **caractérisée en ce que** la teneur en pigments blancs est comprise entre entre 20 et 35% en poids, par rapport au poids total de la composition.

12. Composition selon l'une quelconque des revendications 1 à 11, **caractérisée en ce que** les pigments blancs sont du dioxyde de titane TiO₂.

13. Composition selon l'une quelconque des revendications 1 à 12, **caractérisée en ce que** la teneur en renforts est comprise entre 5 et 30% en poids, par rapport au poids total de la composition.

14. Composition selon l'une quelconque des revendications 1 à 13, **caractérisée en ce que** la teneur en renforts est comprise entre 10 et 15% en poids, par rapport au poids total de la composition.

15. Composition selon l'une quelconque des revendications 1 à 14, **caractérisée en ce que** les renforts se présentent sous la forme de fibres, telles que des fibres de verre.

16. Composition selon l'une quelconque des revendications 1 à 15, **caractérisée en ce que** la teneur en hydroxyde métallique et/ou en oxyde métallique est comprise entre 0,5 et 5% en poids, par rapport au poids total de la composition.

17. Composition selon l'une quelconque des revendications 1 à 15, **caractérisée en ce que** la teneur en hydroxyde métallique et/ou en oxyde métallique est comprise entre 1 et 3,5% en poids, par rapport au poids total de la composition.

18. Composition selon l'une quelconque des revendications 1 à 17, **caractérisée en ce que** l'hydroxyde métallique est choisi parmi l'hydroxyde de magnésium Mg(OH)₂, l'hydroxyde de calcium Ca(OH)₂ et l'hydroxyde d'aluminium Al(OH)₃.

19. Composition selon l'une quelconque des revendications 1 à 17, **caractérisée en ce que** l'hydroxyde métallique est l'hydroxyde de magnésium Mg(OH)₂.

20. Composition selon l'une quelconque des revendications 1 à 19, **caractérisée en ce que** l'oxyde métallique est choisi parmi l'oxyde de magnésium MgO et l'oxyde de calcium CaO.

21. Composition selon l'une quelconque des revendications 1 à 20, **caractérisée en ce que** la teneur en phosphite organique est comprise entre 0,1 et 2% en poids, par rapport au poids total de la composition.

22. Composition selon l'une quelconque des revendications 1 à 20, **caractérisée en ce que** la teneur en phosphite organique est comprise entre 0,5 et 1% en poids, par rapport au poids total de la composition.

23. Composition selon l'une quelconque des revendications 1 à 22, **caractérisée en ce qu'**elle comprend en outre au moins un additif choisi parmi les charges, les agents ignifugeants additionnés ou non d'activateurs d'ignifugation, les stabilisants (tels que stabilisants UV), les plastifiants, les agents tensioactifs, les azurants optiques, les anti-oxydants, les agents démoulants et leurs mélanges.

24. Procédé de préparation d'une composition selon l'une quelconque des revendications 1 à 23, **caractérisé en ce qu'**il comprend une étape de mélange, à l'état fondu, de tous les produits.

25. Utilisation d'une composition telle que définie à l'une quelconque des revendications 1 à 23 pour constituer tout ou partie d'une pièce électronique, destinée notamment à l'industrie électrique ou électronique.

26. Utilisation selon la revendication 25, **caractérisée en ce que** la pièce électronique est un connecteur, un commutateur ou un réflecteur à diode électroluminescente (LED).

27. Réflecteur à diode électroluminescente (LED) constitué en tout ou partie par un matériau obtenu à partir d'une composition telle que définie à l'une quelconque des revendications 1 à 23.

## Patentansprüche

1. Zusammensetzung, die Folgendes umfasst, wobei die Gewichtsprozentanteile unter Bezugnahme auf das Gesamtgewicht der Zusammensetzung angegeben sind:
- 30 bis 97 Gewichts-% mindestens eines halbaromatischen Polyamids, das Folgendes umfasst:
. 55 bis 100 Mol-% eines Wiederholbausteins (A), der ausgehend von der Polykondensation mindestens eines aliphatischen Diamins, welches 4 bis 18 Kohlenstoffatome umfasst, und mindestens einer aromatischen Dicarbonsäure, wobei Terephthalsäure dazugehört, erhalten wird, und
. 0 bis 45 Mol-% eines Wiederholbausteins (B), der ausgehend von mindestens einem Element erhalten wird, welches aus der Gruppe ausgewählt ist, die aus einem Lactam, welches 9 bis 12 Kohlenstoffatome umfasst, einer nichtaromatischen Aminocarbonsäure, welche 9 bis 12 Kohlenstoffatome umfasst, und dem Polykondensationsprodukt mindestens eines Diamins, welches 4 bis 36 Kohlenstoffatome umfasst, und mindestens einer nichtaromatischen Dicarbonsäure, welche 4 bis 36 Kohlenstoffatome umfasst, besteht,
- 2 bis 50 Gewichts-% an Weißpigmenten,
- 0 bis 50 Gewichts-% an Verstärkungsmitteln, und
- 0,1 bis 10 Gewichts-% mindestens eines Metallhydroxids und/oder mindestens eines Metalloxids, mit Ausnahme eines Übergangsmetalloxids,
wobei die Zusammensetzung darüber hinaus ein organisches Phosphit umfasst, dessen Gehalt bis zu 3 Gewichts-% ausmachen kann.

2. Zusammensetzung nach Anspruch 1, **dadurch gekennzeichnet, dass** das oder die halbaromatische(n) Polyamid(e) eine Schmelztemperatur von mindestens 260 °C haben, wobei die Schmelztemperatur mittels DSC gemessen wird, gemäß der Norm ISO 11357.

3. Zusammensetzung nach Anspruch 1, **dadurch gekennzeichnet, dass** das oder die halbaromatische(n) Polyamid(e) eine Schmelztemperatur von mindestens 270 °C haben, wobei die Schmelztemperatur mittels DSC gemessen wird, gemäß der Norm ISO 11357.

4. Zusammensetzung nach Anspruch 1, **dadurch gekennzeichnet, dass** das oder die halbaromatische(n) Polyamid(e) eine Schmelztemperatur von mindestens 280 °C haben, wobei die Schmelztemperatur mittels DSC gemessen wird, gemäß der Norm ISO 11357.

5. Zusammensetzung nach einem beliebigen der Ansprüche 1 bis 4, **dadurch gekennzeichnet, dass** das aliphatische Diamin des Wiederholbausteins (A) geradkettig ist und 6 bis 14 Kohlenstoffatome umfasst.

6. Zusammensetzung nach einem beliebigen der Ansprüche 1 bis 4, **dadurch gekennzeichnet, dass** das aliphatische Diamin des Wiederholbausteins (A) geradkettig ist und 10 Kohlenstoffatome umfasst.

7. Zusammensetzung nach einem beliebigen der Ansprüche 1 bis 6, **dadurch gekennzeichnet, dass** das Lactam 10 bis 12 Kohlenstoffatome umfasst.

8. Zusammensetzung nach einem beliebigen der Ansprüche 1 bis 7, **dadurch gekennzeichnet, dass** die Aminocarbonsäure 10 bis 12 Kohlenstoffatome umfasst.

9. Zusammensetzung nach einem beliebigen der Ansprüche 1 bis 7, **dadurch gekennzeichnet, dass** die Aminocarbonsäure 11 Kohlenstoffatome umfasst.

10. Zusammensetzung nach einem beliebigen der Ansprüche 1 bis 9, **dadurch gekennzeichnet, dass** der Gehalt an Weißpigmenten im Bereich von 10 bis 40 Gewichts-% liegt, unter Bezugnahme auf das Gesamtgewicht der Zusammensetzung.

11. Zusammensetzung nach einem beliebigen der Ansprüche 1 bis 9, **dadurch gekennzeichnet, dass** der Gehalt an Weißpigmenten im Bereich von 20 bis 35 Gewichts-% liegt, unter Bezugnahme auf das Gesamtgewicht der Zusammensetzung.

12. Zusammensetzung nach einem beliebigen der Ansprüche 1 bis 11, **dadurch gekennzeichnet, dass** es sich bei den Weißpigmenten um Titandioxid TiO₂ handelt.

13. Zusammensetzung nach einem beliebigen der Ansprüche 1 bis 12, **dadurch gekennzeichnet, dass** der Gehalt an Verstärkungsmitteln im Bereich von 5 bis 30 Gewichts-% liegt, unter Bezugnahme auf das Gesamtgewicht der Zusammensetzung.

14. Zusammensetzung nach einem beliebigen der Ansprüche 1 bis 13, **dadurch gekennzeichnet, dass** der Gehalt an Verstärkungsmitteln im Bereich von 10 bis 15 Gewichts-% liegt, unter Bezugnahme auf das Gesamtgewicht der Zusammensetzung.

15. Zusammensetzung nach einem beliebigen der Ansprüche 1 bis 14, **dadurch gekennzeichnet, dass** die Verstärkungsmittel in Form von Fasern, wie etwas Glasfasern, vorliegen.

16. Zusammensetzung nach einem beliebigen der Ansprüche 1 bis 15, **dadurch gekennzeichnet, dass** der Gehalt an Metallhydroxid und/oder Metalloxid im Bereich von 0,5 bis 5 Gewichts-% liegt, unter Bezugnahme auf das Gesamtgewicht der Zusammensetzung.

17. Zusammensetzung nach einem beliebigen der Ansprüche 1 bis 15, **dadurch gekennzeichnet, dass** der Gehalt an Metallhydroxid und/oder Metalloxid im Bereich von 1 bis 3,5 Gewichts-% liegt, unter Bezugnahme auf das Gesamtgewicht der Zusammensetzung.

18. Zusammensetzung nach einem beliebigen der Ansprüche 1 bis 17, **dadurch gekennzeichnet, dass** das Metallhydroxid aus Magnesiumhydroxid Mg(OH)₂, Calciumhydroxid Ca(OH)₂ und Aluminiumhydroxid Al(OH)₃ ausgewählt ist.

19. Zusammensetzung nach einem beliebigen der Ansprüche 1 bis 17, **dadurch gekennzeichnet, dass** es sich bei dem Metallhydroxid um Magnesiumhydroxid Mg(OH)₂ handelt.

20. Zusammensetzung nach einem beliebigen der Ansprüche 1 bis 19, **dadurch gekennzeichnet, dass** das Metalloxid aus Magnesiumoxid MgO und Calciumoxid CaO ausgewählt ist.

21. Zusammensetzung nach einem beliebigen der Ansprüche 1 bis 20, **dadurch gekennzeichnet, dass** der Gehalt an organischem Phosphit im Bereich von 0,1 bis 2 Gewichts-% liegt, unter Bezugnahme auf das Gesamtgewicht der Zusammensetzung.

22. Zusammensetzung nach einem beliebigen der Ansprüche 1 bis 20, **dadurch gekennzeichnet, dass** der Gehalt an organischem Phosphit im Bereich von 0,5 bis 1 Gewichts-% liegt, unter Bezugnahme auf das Gesamtgewicht der Zusammensetzung.

23. Zusammensetzung nach einem beliebigen der Ansprüche 1 bis 22, **dadurch gekennzeichnet, dass** sie darüber hinaus mindestens einen Zusatzstoff umfasst, der aus den Füllstoffen, den Flammschutzmitteln mit oder ohne Flammschutzaktivator, den Stabilisatoren (wie etwa UV-Stabilisatoren), den Weichmachern, den Tensiden, den optischen Aufhellern, den Antioxidantien, den Trennmitteln und deren Mischungen ausgewählt ist.

24. Verfahren zur Herstellung einer Zusammensetzung nach einem beliebigen der Ansprüche 1 bis 23, **dadurch gekennzeichnet, dass** es einen Schritt des Mischens sämtlicher Stoffe, in geschmolzenem Zustand, umfasst.

25. Verwendung einer Zusammensetzung, wie sie in einem beliebigen der Ansprüche 1 bis 23 definiert ist, um ein elektronische Bauteil vollständig oder teilweise zu bilden, welches insbesondere für die Elektro- und Elektronikindustrie bestimmt ist.

26. Verwendung nach Anspruch 25, **dadurch gekennzeichnet, dass** es sich bei dem elektronischen Bauteil um ein Verbindungsstück, einen Umschalter oder einen Reflektor mit Leuchtdiode (LED) handelt.

27. Reflektor mit Leuchtdiode (LED), der vollständig oder teilweise aus einem Material besteht, welches ausgehend von einer Zusammensetzung erhalten wird, wie sie in einem beliebigen der Ansprüche 1 bis 23 definiert ist.

## Claims

1. A composition comprising, the weight percentages being given relative to the total weight of the composition:
- from 30% to 97% by weight of at least one semiaromatic polyamide comprising:
. from 55 mol% to 100 mol% of a repeating unit (A) obtained from the polycondensation of at least one aliphatic diamine comprising from 4 to 18 carbon atoms and of at least one aromatic dicarboxylic acid including terephthalic acid, and
. from 0 to 45 mol% of a repeating unit (B) obtained from at least one element chosen from the group consisting of a lactam comprising from 9 to 12 carbon atoms, a nonaromatic aminocarboxylic acid comprising from 9 to 12 carbon atoms and the product of polycondensation of at least one diamine comprising from 4 to 36 carbon atoms and of at least one nonaromatic dicarboxylic acid comprising from 4 to 36 carbon atoms,
- from 2% to 50% by weight of white pigments,
- from 0 to 50% by weight of reinforcers, and
- from 0.1% to 10% by weight of at least one metal hydroxide and/or of at
least one metal oxide, with the exception of a transition metal oxide, said composition also comprising an organic phosphite, in a content which may be up to 3% by weight.

2. The composition as claimed in claim 1, **characterized in that** the semiaromatic polyamide(s) have a melting point of at least 260°C, the melting point being measured by DSC, according to standard ISO 11357.

3. The composition as claimed in claim 1, **characterized in that** the semiaromatic polyamide(s) have a melting point of at least 270°C, the melting point being measured by DSC, according to standard ISO 11357.

4. The composition as claimed in claim 1, **characterized in that** the semiaromatic polyamide(s) have a melting point of at least 280°C, the melting point being measured by DSC, according to standard ISO 11357.

5. The composition as claimed in any one of claims 1 to 4, **characterized in that** the aliphatic diamine of the repeating unit (A) is linear and comprises from 6 to 14 carbon atoms.

6. The composition as claimed in any one of claims 1 to 4, **characterized in that** the aliphatic diamine of the repeating unit (A) is linear and comprises 10 carbon atoms.

7. The composition as claimed in any one of claims 1 to 6, **characterized in that** the lactam comprises from 10 to 12 carbon atoms.

8. The composition as claimed in any one of claims 1 to 7, **characterized in that** the aminocarboxylic acid comprises from 10 to 12 carbon atoms.

9. The composition as claimed in any one of claims 1 to 7, **characterized in that** the aminocarboxylic acid comprises 11 carbon atoms.

10. The composition as claimed in any one of claims 1 to 9, **characterized in that** the content of white pigments is between 10% and 40% by weight relative to the total weight of the composition.

11. The composition as claimed in any one of claims 1 to 9, **characterized in that** the content of white pigments is between 20% and 35% by weight relative to the total weight of the composition.

12. The composition as claimed in any one of claims 1 to 11, **characterized in that** the white pigments are titanium dioxide TiO₂.

13. The composition as claimed in any one of claims 1 to 12, **characterized in that** the content of reinforcers is between 5% and 30% by weight relative to the total weight of the composition.

14. The composition as claimed in any one of claims 1 to 13, **characterized in that** the content of reinforcers is between 10% and 15% by weight relative to the total weight of the composition.

15. The composition as claimed in any one of claims 1 to 14, **characterized in that** the reinforcers are in the form of fibers, such as glass fibers.

16. The composition as claimed in any one of claims 1 to 15, **characterized in that** the content of metal hydroxide and/or of metal oxide is between 0.5% and 5% by weight relative to the total weight of the composition.

17. The composition as claimed in any one of claims 1 to 15, **characterized in that** the content of metal hydroxide and/or of metal oxide is between 1% and 3.5% by weight relative to the total weight of the composition.

18. The composition as claimed in any one of claims 1 to 17, **characterized in that** the metal hydroxide is chosen from magnesium hydroxide Mg(OH)₂, calcium hydroxide Ca(OH)₂ and aluminum hydroxide Al(OH)₃.

19. The composition as claimed in any one of claims 1 to 17, **characterized in that** the metal hydroxide is magnesium hydroxide Mg(OH)₂.

20. The composition as claimed in any one of claims 1 to 19, **characterized in that** the metal oxide is chosen from magnesium oxide MgO and calcium oxide CaO.

21. The composition as claimed in any one of claims 1 to 20, **characterized in that** the content of organic phosphite is between 0.1% and 2% by weight relative to the total weight of the composition.

22. The composition as claimed in any one of claims 1 to 20, **characterized in that** the content of organic phosphite is between 0.5% and 1% by weight relative to the total weight of the composition.

23. The composition as claimed in any one of claims 1 to 22, **characterized in that** it also comprises at least one additive chosen from fillers, flame retardants optionally supplemented with flame-retardant activators, stabilizers (such as UV stabilizers), plasticizers, surfactants, optical brighteners, antioxidants and mold-release agents, and mixtures thereof.

24. A process for preparing a composition as claimed in any one of claims 1 to 23, **characterized in that** it comprises a step of melt-blending of all the products.

25. The use of a composition as defined in any one of claims 1 to 23, for making all or part of an electronic part, intended especially for the electrical or electronics industry.

26. The use as claimed in claim 25, **characterized in that** the electronic part is a light-emitting diode (LED) connector, switch or reflector.

27. A light-emitting diode (LED) reflector consisting totally or partly of a material obtained from a composition as defined in any one of claims 1 to 23.
